# FASCICULE DE BREVET EUROPEEN

(11) **EP 3 071 933 B1**
(45) Date de publication et mention de la délivrance du brevet: **01.07.2020**
(21) Numéro de dépôt: 14802026.6
(22) Date de dépôt: 20.11.2014
(51) Int. Cl.: G01P 15/08, G01C 19/574, B81B 3/00, G01P 15/097

(54) **CAPTEUR COMPRENANT DES MASSES MOBILES ET DES MOYENS DE DÉTECTION DES MOUVEMENTS RELATIFS DES MASSES**
SENSOR MIT BEWEGLICHEN MASSEN UND MITTEL ZUM ERFASSEN VON RELATIVBEWEGUNGEN DER MASSEN
SENSOR INCLUDING MOVING MASSES AND MEANS FOR DETECTING RELATIVE MOVEMENTS OF THE MASSES

(30) Priorité: 20.11.2013 FR 1361435
(43) Date de publication de la demande: 28.09.2016
(73) Titulaire: Safran Electronics & Defense, 92100 Boulogne-Billancourt (FR)
(72) Inventeur: JEANROY, Alain, 92100 Boulogne Billancourt (FR); ONFROY, Philippe, 92100 Boulogne-Billancourt (FR)
(74) Mandataire: Lavialle, Bruno François Stéphane
(86) Numéro de dépôt international: PCT/EP2014/075115
(87) Numéro de publication internationale: WO 2015/075115

(56) Documents cités:
- FR-A1- 2 983 574
- JP-A- H10 270 715
- US-A1- 2012 125 098

## Description

La présente invention concerne un capteur inertiel tel que défini dans la revendication 1, comme par exemple un gyroscope ou un gyromètre.

Un tel capteur inertiel comprend un bâti et des corps sismiques (couramment appelés masses sismiques ou masses d'épreuve) qui sont généralement disposés côte-à-côte et reliés au bâti par des charnières élastiques pour être mobiles dans un plan de suspension défini par deux directions orthogonales de déplacement des corps sismiques. L'élasticité des charnières associée à la masse des corps sismiques définit les fréquences des modes propres des corps sismiques.

Le résonateur constitué par les corps sismiques et les charnières élastiques possède deux modes utiles de vibration, définissant deux directions de déplacement des corps sismiques. La détection des vibrations des corps sismiques selon ces directions permet d'effectuer une mesure angulaire.

Le capteur comprend également des actionneurs agencés pour mettre en vibration les corps sismiques et des détecteurs agencés pour détecter des mouvements relatifs des corps sismiques. Les détecteurs comprennent généralement des paires d'électrodes dont l'une est solidaire de l'un des corps sismiques et l'autre est solidaire du bâti. Ceci permet de détecter les mouvements des corps sismiques puis par traitement de déterminer le mouvement des corps sismiques l'un par rapport à l'autre. Toutefois, les mesures incorporent des composantes liées à des mouvements parasites entre les corps sismiques et le bâti dus aux autres modes propres des corps sismiques, ces composantes pouvant se révéler particulièrement préjudiciables pour les performances du capteur lorsque les détecteurs ont des gains différents.

Les exigences en matière de détection d'attitude et de vitesse, par exemple aux fins de pilotage de véhicule ou de navigation, imposent une amélioration des performances de ces capteurs.

Différentes solutions ont été proposées comme, par exemple, dans les documents US 2012/125098 et FR-A-2983574.

L'invention vise à améliorer les performances des capteurs, comme notamment le document précédent et peut bénéficier de l'enseignement de celui-ci, mais relève néanmoins d'une approche différente.

Par l'invention, on a voulu simplifier la détection des mouvements relatifs des corps sismiques en limitant les traitements nécessaires à cette fin. En effet, on s'est aperçu que ces traitements engendraient des imprécisions altérant les performances des capteurs.

Dans ce but, on prévoit, selon l'invention, un capteur inertiel de type MEMS, comprenant un bâti, au moins un premier corps sismique et un deuxième corps sismique reliés audit bâti par des moyens élastiques du capteur pour être mobiles dans un plan de suspension, des transducteurs pour maintenir en vibration les corps sismiques et pour déterminer un mouvement des corps sismiques dans le plan de suspension, et une unité de commande reliée aux transducteurs par des moyens de conduction électrique. Les transducteurs comportent au moins une électrode solidaire du premier corps sismique et une électrode solidaire du deuxième corps sismique, les deux électrodes étant agencées pour permettre de mesurer directement le mouvement relatif des corps sismiques l'un par rapport à l'autre dans le plan de suspension selon au moins deux directions parallèles au plan de suspension.

Ainsi, le mouvement relatif des corps sismiques est déterminé directement au moyen des électrodes solidaires des corps sismiques.

Les transducteurs comportent de préférence des électrodes solidaires respectivement du premier corps sismique et du deuxième corps sismique selon au moins deux directions parallèles au plan de suspension, les électrodes étant agencées pour permettre de mesurer directement le mouvement relatif des corps sismiques l'un par rapport à l'autre dans le plan de suspension.

Avantageusement, le capteur comprend au moins une première couche semi-conductrice dans laquelle sont formées au moins une partie des corps sismiques, les moyens élastiques et les électrodes, une première couche isolante électriquement, et une deuxième couche semi-conductrice formant support. La première couche semi-conductrice est pourvue de rainures sur toute sa hauteur pour définir des chemins de conduction électrique s'étendant depuis les électrodes vers une périphérie du bâti via les moyens élastiques de manière à former au moins une partie des moyens de conduction.

La réalisation de chemins de conduction dans la première couche semi-conductrice en utilisant les moyens élastiques permet la transmission des signaux de mesure sans recourir à des moyens de liaison externes risquant d'engendrer des perturbations du mouvement des corps sismiques.

D'autres caractéristiques et avantages de l'invention ressortiront à la lecture de la description qui suit de modes de réalisation particuliers non limitatifs de l'invention.

Il sera fait référence aux dessins annexés, parmi lesquels :
- la figure 1 est une vue en perspective de ce capteur,
- la figure 2 est une vue en perspective d'une partie du boîtier de ce capteur,
- la figure 3 est une vue en perspective d'un des corps sismiques d'un capteur selon un premier mode de réalisation de l'invention,
- la figure 4 est une vue analogue à la figure 1 de l'autre des corps sismiques de ce capteur,
- la figure 5 est une vue en perspective de ce capteur, sans le boîtier,
- la figure 6 est une vue de dessus d'un capteur selon un deuxième mode de réalisation, boîtier ôté,
- la figure 7 est une vue en coupe de ce capteur selon la ligne VII-VII de la figure 6,
- la figure 8 est une vue analogue à la figure 6 d'une variante du deuxième mode de réalisation.

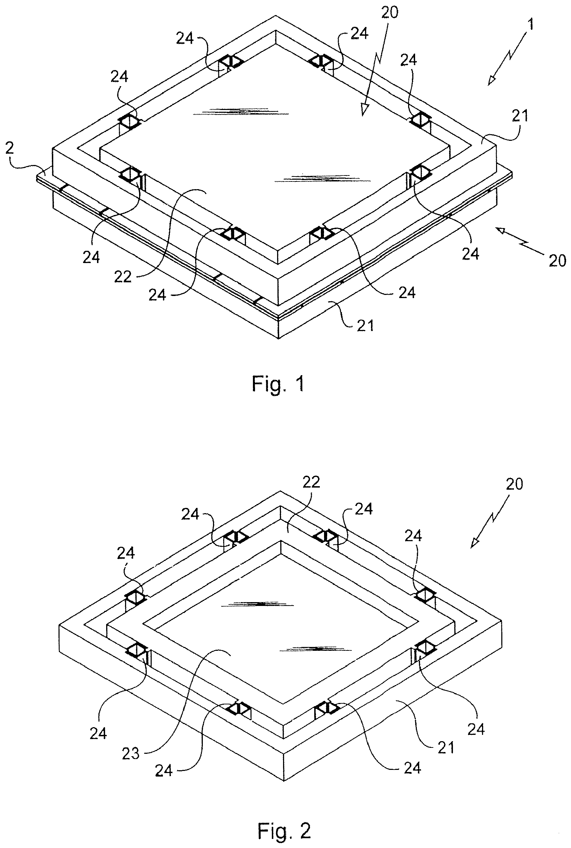

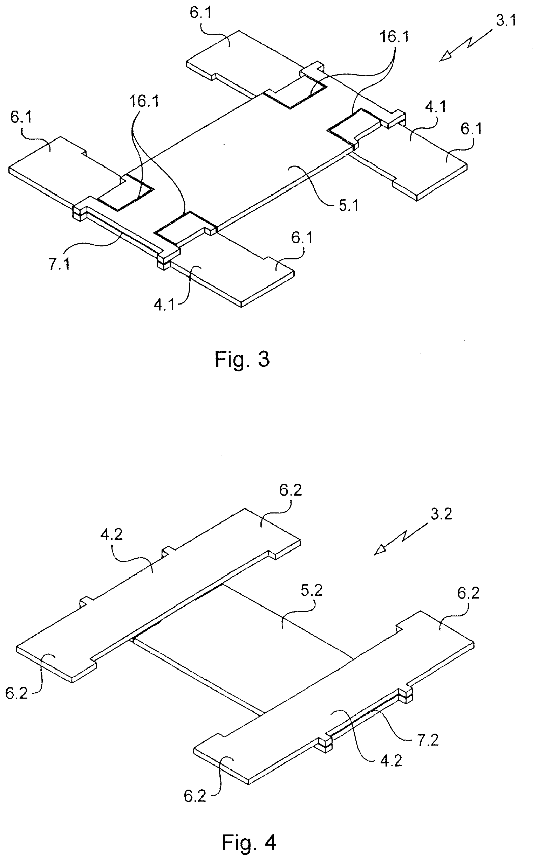

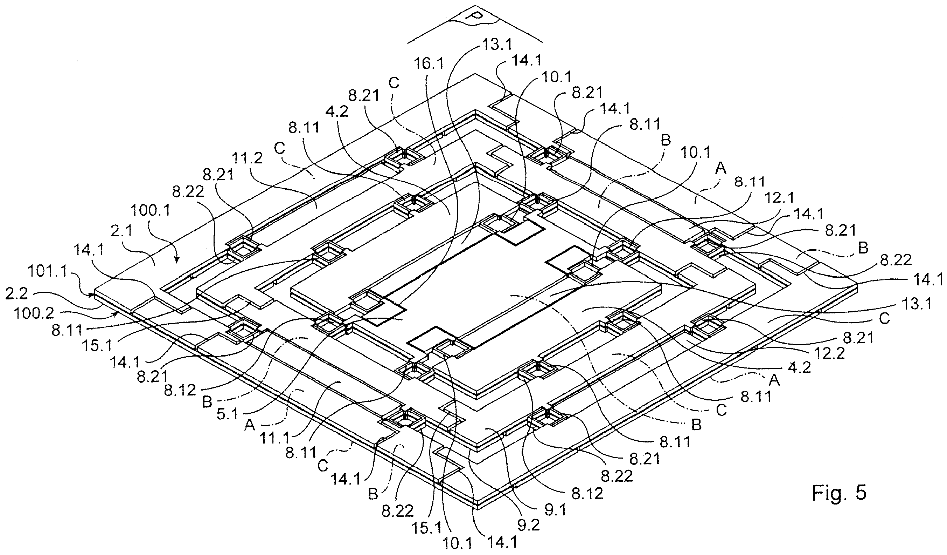

En référence aux figures 1 à 5, le capteur selon le premier mode de réalisation de l'invention, généralement désigné en 1, est ici un capteur de type MEMS (de l'anglais « Micro Electro-Mechanical System ») réalisé à partir d'une galette comportant deux couches semi-conductrices 100.1, 100.2 et une couche isolante électriquement 101.1. La couche isolante 101.1 s'étend entre la première couche semi-conductrice 100.1 et la deuxième couche semi-conductrice 100.2. Les couches semi-conductrices 100.1, 100.2 sont en matériau semi-conducteur, ici en silicium, et la couche isolante 101.1 est en un oxyde de silicium tel que le SiO₂.

Dans chaque couche semi-conductrice 100.1, 100.2 sont formés :
- un bâti 2.1, 2.2 formant un cadre externe ;
- un cadre intermédiaire 9.1, 9.2 ;
- des portions de corps sismiques généralement désignés en 3.1, 3.2 ;
- des premiers éléments élastiques 8.11, 8.12 reliant le corps sismique 3.1, 3.2 au cadre intermédiaire 9.1, 9.2 ;
- des deuxièmes éléments élastiques 8.21, 8.22 reliant le cadre intermédiaire 9.1, 9.2 au bâti 2.1, 2.2 ;
- des troisièmes éléments élastiques 10.1, 10.2 (seuls les éléments élastiques 10.1 sont visibles sur les figures) reliant les portions de corps sismiques 3.1, 3.2 entre elles ;
- des premiers transducteurs 11.1, 11.2 s'étendant entre un premier côté du bâti 2.1, 2.2 et un premier côté du cadre intermédiaire 9.1, 9.2 en regard ;
- des deuxièmes transducteurs 12.1, 12.2 s'étendant entre un deuxième côté du bâti 2.1, 2.2 et un deuxième côté du cadre intermédiaire 9.1, 9.2 en regard, le deuxième côté portant les transducteurs 12.1 étant à l'opposé du premier côté portant les transducteurs 11.1 et le deuxième côté portant les transducteurs 12.2 étant à l'opposé du premier côté portant les transducteurs 11.2 ;
- des troisièmes transducteurs 13.1, 13.2 (seuls les transducteurs 13.1 sont visibles sur les figures) s'étendant entre les portions de corps sismiques 3.1, 3.2.

Chaque corps sismique 3.1, 3.2 comprend respectivement deux ailes 4.1, 4.2 parallélépipédiques qui s'étendent parallèlement l'une à l'autre en étant écartées l'une de l'autre et sont reliées l'une à l'autre par une âme centrale 5.1, 5.2 parallélépipédique s'étendant en retrait des ailes 4.1, 4.2. L'âme centrale 5.1, 5.2 a une largeur inférieure à l'écartement des ailes 4.1, 4.2. Les ailes 4.1 du corps sismique 3.1 sont formées dans la couche semi-conductrice 100.2 et l'âme centrale 5.1 du corps sismique 3.1 est formée dans la couche semi-conductrice 100.1. Les ailes 4.2 du corps sismique 3.2 sont formées dans la couche semi-conductrice 100.1 et l'âme centrale 5.2 du corps sismique 3.2 est formée dans la couche semi-conductrice 100.2. Une portion 7.1, 7.2 de la couche isolante entre 100.1, 100.2 s'étend entre les ailes 4.1, 4.2 et l'âme 5.1, 5.2 pour isoler électriquement les ailes 4.1, 4.2 de l'âme 5.1, 5.2.

Les corps sismiques 3.1, 3.2 sont montés mobiles selon un plan prédéterminé P. Les corps sismiques 3.1, 3.2 ont une même forme et une même masse. Les corps sismiques 3.1, 3.2 sont positionnés pour avoir des centres de gravité confondus l'un avec l'autre. Chaque aile 4.1, 4.2 a une masse inférieure de moitié à la masse de l'âme 5.1, 5.2.

Les agencements des couches semi-conductrices 100.1, 100.2 sont orientés à 90° l'un par rapport à l'autre autour d'un axe normal au plan prédéterminé P et à 180° autour d'un axe du plan prédéterminé P de telle manière que l'âme 5.1, 5.2 de chacun des corps sismiques 3.1, 3.2 s'étende en regard de l'âme 5.1, 5.2 et entre les ailes 4.1, 4.2 de l'autre des corps sismiques 3.1, 3.2. Ainsi, les ailes 4.1, 4.2 de chacun des corps sismiques 3.1, 3.2 ont des portions d'extrémité 6.1, 6.2 s'étendant dans le même plan que l'âme 5.2, 5.1 de l'autre des corps sismiques 3.2, 3.1 et en regard de portions d'extrémité 6.2, 6.1 des ailes 4.2, 4.1 de l'autre des corps sismiques 3.2, 3.1.

Les corps sismiques 3.1, 3.2 comportent ainsi des parties d'emboîtement (les ailes 4.1, 4.2) de telle manière que les corps sismiques 3.1, 3.2 soient mutuellement imbriqués l'un dans l'autre tout en étant mobiles chacun selon le plan prédéterminé P relativement à l'autre des corps sismiques 3.2, 3.1.

Les premiers éléments élastiques 8.11, 8.12 et les deuxièmes éléments élastiques 8.21, 8.22 forment un premier étage de suspension et un deuxième étage de suspension des corps sismiques 3.1, 3.2.

Les éléments élastiques sont ici formés de lamelles élastiquement déformables parallèlement au plan de suspension P, mais qui présentent une raideur élevée selon l'axe normal au plan de suspension pour supprimer les degrés de liberté des corps sismiques 3.1, 3.2 hors du plan de suspension P. Les éléments élastiques 8.11, 8.12, 8.21, 8.22 sont agencés pour assurer un couplage relativement faible du cadre intermédiaire 9.1, 9.2 avec les corps sismiques 3.1, 3.2 et avec le bâti 2.1, 2.2. Les premiers éléments élastiques 8.11, 8.12 ont des raideurs isotropes dans le plan P. Les deuxièmes éléments élastiques 8.21, 8.22 ont des raideurs isotropes dans le plan P. Les raideurs des premiers éléments élastiques 8.11, 8.12 et des deuxièmes éléments élastiques 8.21, 8.22 sont telles que les fréquences du premier mode propre du cadre intermédiaire 9.1, 9.2 et du mode propre d'ensemble des corps sismiques 3.1; 3.2 soient sensiblement inférieures à la fréquence des modes utiles. Les éléments élastiques 10.1, 10.2 ont des raideurs isotropes dans le plan P et sont agencés pour assurer un couplage relativement fort des corps sismiques 3.1, 3,2 entre eux. Les éléments élastiques 10.1, 10.2 ont donc une raideur supérieure à la raideur des éléments élastiques 8.11, 8.12, 8.21, 8.22.

Deux éléments élastiques 10.2 s'étendent parallèlement à l'âme centrale 5.1 entre chacune des ailes 4.1 du corps sismique 3.1 et l'âme centrale 5.2 du corps sismique 3.2 et deux éléments élastiques 10.1 s'étendent parallèlement à l'âme centrale 5.2 entre chacune des ailes 4.2 du corps sismique 3.2 et l'âme centrale 5.1 du corps sismique 3.1.

Les transducteurs 13 sont reliés à une unité de commande, non représentée ici, pour déterminer le mouvement relatif des corps sismiques 3.1, 3.2 l'un par rapport à l'autre.

Les transducteurs 11.1, 11.2 sont pilotés par l'unité de commande de manière à former successivement sur un premier axe un détecteur du déplacement relatif du cadre intermédiaire 9.1, 9.2 par rapport au bâti 2.1, 2.2 et un actionneur d'amortissement du premier mode propre de vibration du cadre intermédiaire 9.1, 9.2 par rapport au bâti 2.1, 2.2.

Les transducteurs 12.1, 12.2 sont pilotés par l'unité de commande de manière à former successivement sur un deuxième axe un détecteur du déplacement relatif du cadre intermédiaire 9.1, 9.2 par rapport au bâti 2.1, 2.2 et un actionneur d'amortissement du premier mode propre de vibration du cadre intermédiaire 9.1, 9.2 par rapport au bâti 2.1, 2.2.

Les transducteurs 13.1, 13.2 sont pilotés par l'unité de commande de manière à former successivement un actionneur de mise en vibration des corps sismiques 3.1, 3.2 et un détecteur du déplacement relatif des corps sismiques 3.1, 3.2.

Deux des transducteurs 13.2 s'étendent entre chacune des ailes 4.1 du corps sismique 3.1 et l'âme centrale 5.2 du corps sismique 3.2 et deux des transducteurs 13.1 s'étendent entre chacune des ailes 4.2 du corps sismique 3.2 et l'âme centrale 5.1 du corps sismique 3.1. Les transducteurs 13.1 ont la forme de deux électrodes, par exemple en peigne, qui pour chaque transducteur sont solidaires pour l'une de l'aile 4.1, 4.2 et pour l'autre de l'âme centrale 5.2, 5.1. Les électrodes sont d'une seule pièce avec les ailes 4.1, 4.2 et les âmes centrales 5.1, 5.2. On notera que les portions 7.1, 7.2 de couche isolante 101.1 permettent d'avoir des ailes 4.1, 4.2 et des âmes centrales 5.1, 5.2 à des potentiels différents. Les transducteurs sont ainsi disposés selon deux directions parallèles au plan de suspension.

La couche semi-conductrice 100.1, 100.2 comporte des fentes 14.1, 14.2 (seules les fentes 14.1 sont visibles) au niveau du premier côté et du deuxième côté du bâti 2.1, 2.2 pour délimiter une zone A en regard de chaque transducteur 11.1, 11.2 ; une zone B de part et d'autre de la zone A et en regard des deuxièmes éléments 8.21, 8.22 et une zone C entre les deux zones B.

La couche semi-conductrice 100.1, 100.2 comporte des fentes 15.1, 15.2 2 (seules les fentes 15.1 sont visibles) au niveau du premier côté et du deuxième côté du cadre intermédiaire 9.1, 9.2 pour délimiter une zone B en regard de chaque transducteur 11.1, 11.2, des deuxièmes éléments élastiques 8.21, 8.22 et des premiers éléments élastiques 8.11, 8.12, et une zone C entre les deux zones B.

La couche semi-conductrice 100.1, 100.2 comporte des fentes 16.1, 16.2 autour des troisièmes éléments élastiques 10.1, 10.2 pour délimiter une zone B en regard des premiers éléments élastiques 8.11, 8.12 et des transducteurs 13.1, 13.2.

Les transducteurs 11 et 12 ont chacun une électrode solidaire d'une zone B et une électrode solidaire d'une zone A. Les transducteurs 13 ont chacun une électrode solidaire d'une zone B et une électrode solidaire d'une zone C. Les électrodes sont ici en forme de peigne. Comme les fentes 14, 15, 16 s'étendent sur toute la hauteur de la couche semi-conductrice 100.1, 100.2, les zones A, B, C sont électriquement isolées et peuvent être portées à des potentiels différents pour transmettre des signaux de commande et/ou de détection. Les couches semi-conductrices 100.1, 100.2 étant séparées l'une de l'autre par la couche isolante 101.1, les zones A, B, C de la couche semi-conductrice 100.1 sont électriquement isolées des zones A, B, C de la couche semi-conductrice 100.2.

Les zones A, B, C permettent la conduction d'un signal de tension entre les transducteurs 11, 12, 13 et la périphérie du bâti 2.1, 2.2. L'unité de commande est électriquement connectée aux zones A, B, C au niveau de la périphérie du bâti 2.1, 2.2.

En fonctionnement les transducteurs 13 sont pilotés pour alternativement :
- mettre et maintenir en vibration l'ensemble corps sismiques 3.1, 3.2 et éléments élastiques 8.11, 8.12, 10.1, 10.2 à la fréquence de résonance de cet ensemble ;
- détecter les mouvements relatifs des corps sismiques 3.1, 3.2 entre eux. Les transducteurs permettent de détecter le mouvement relatifs des corps sismiques 3.1, 3.2 selon n'importe quelle direction parallèle au plan de suspension.

Les transducteurs 11, 12 sont par exemple commandés pour créer une raideur électrostatique réglable du deuxième étage de suspension.

Le capteur peut comprendre un boîtier formé de deux parties généralement désignées en 20 entre lesquelles sont emprisonnés l'ensemble bâti 2.1, 2.2 / cadre intermédiaire 9.1, 9.2 / corps sismiques 3.1, 3.2 (et les transducteurs et moyens élastiques associés). Chaque partie 20 comprend un cadre 21 solidaire du bâti 1, et un capot 22 solidaire du cadre intermédiaire 9.1, 9.2 et relié au cadre 21 par des moyens élastiques 24. Le capot 22 de chaque partie 20 comporte une cavité 23 s'étendant en regard des corps sismiques 3.1, 3.2. Les capots 22 sont fixés sur le cadre support 9 de telle manière que la cavité 23 puisse être maintenue sous vide. Le capot 22 a une masse suffisante pour constituer une masse de recul pour les modes propres des corps sismiques 3.1, 3.2 permettant de séparer les fréquences des modes utiles et du mode de suspension créé par les deuxièmes éléments élastiques 8.21, 8.22 et d'atténuer au moins une partie des efforts parasites en provenance de l'extérieur.

Comme les corps sismiques ont des formes et des masses identiques, et que leurs centres de gravité sont confondus, les corps sismiques ont la même inertie et forment un résonateur équilibré qui ne transmet pas d'énergie à l'extérieur à la fréquence des modes utiles et ne subit pas d'influence des effets des vibrations extérieures. Ceci concourt à la stabilité de l'anisotropie d'amortissement, les performances du capteur étant d'autant meilleures que cette anisotropie est stable.

Le capteur selon l'invention est obtenu au moins en partie au moyen d'un procédé de fabrication comportant une phase de gravure de matériau cristallin.

Le procédé de fabrication comprend l'étape de graver le capteur dans la galette comportant les deux couches semi-conductrices 100.1, 100.2 et la couche isolante 101.1.

Les corps sismiques 3.1, 3.2 (ailes 4.1 et 4.2, âmes centrales 5.1 et 5.2, couches isolantes 7.1, 7.2), les bâtis 2.1, 2.2, les cadres intermédiaires 9, les éléments élastiques 8.11, 8.12, 8.21, 8.22, 10.1 et 10.2, les transducteurs 11.1, 11.2, 12.1, 12.2, 13.1, 13.2 et les fentes 14, 15, 16 sont directement issus de la gravure.

Chacune des parties de boîtier 20 est également obtenue par gravure d'un matériau cristallin.

D'une manière générale, on aura recours également aux technologies MEMS classiques regroupées sous le nom générique de « wafer bonding ». Dans le cas présent, on peut citer les techniques dites « direct bonding », « anodic bonding » et « metallic bonding ».

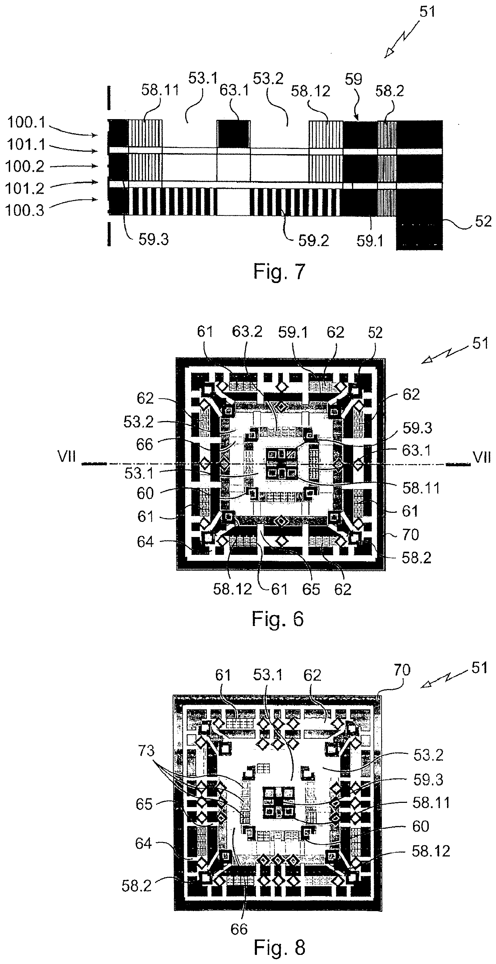

En référence aux figures 6 et 7, et selon le deuxième mode de réalisation, le capteur, généralement désigné en 51, est un capteur de type MEMS réalisé à partir d'une galette comportant trois couches semi-conductrices 100.1, 100.2, 100.3 et deux couches isolantes électriquement 101.1 et 101.2. La première couche isolante 101.1 s'étend entre la première couche semi-conductrice 100.1 et la deuxième couche semi-conductrice 100.2 ; la couche isolante 101.2 s'étend entre la deuxième couche semi-conductrice 100.2 et la troisième couche semi-conductrice 100.3. Les couches semi-conductrices 100.1, 100.2, 100.3 sont en matériau semi-conducteur, ici du silicium, et les couches isolantes 101.1, 101.2 sont en un oxyde de silicium tel que le SiO₂.

Le capteur 51 comprend :
- un bâti 52 formant un cadre externe ;
- un cadre intermédiaire 59 comportant une bordure 59.1 en saillie d'un fond 59.2 depuis le centre duquel s'étend un plot 59.3 ;
- des corps sismiques 53.1, 53.2 agencés sous la forme de cadres concentriques, le corps sismique 53.1 s'étendant entre le corps sismique 53.2 et le plot 59.3 ;
- des premiers éléments élastiques 58.11 reliant le corps sismique 53.1 au plot central 59.3 du cadre intermédiaire 59 ;
- des premiers éléments élastiques 58.12 reliant le corps sismique 53.2 à la bordure 59.1 du cadre intermédiaire 59 ;
- des deuxièmes éléments élastiques 58.2 reliant le cadre intermédiaire 59 au bâti 52 ;
- des troisièmes éléments élastiques 60 reliant les corps sismiques 53.1, 53.2 entre eux ;
- des premiers transducteurs 61 s'étendant chacun entre un des côtés du bâti 52 et un des côtés du cadre intermédiaire 59 en regard ;
- des deuxièmes transducteurs 62 s'étendant chacun entre un des côtés du bâti 52 et un des côtés du cadre intermédiaire 59 en regard ;
- des troisièmes transducteurs 63.1, s'étendant entre des côtés des corps sismiques 3.1, 3.2 en regard, le capteur comportant deux troisièmes transducteurs 63.1 disposés sur deux côtés adjacents ;
- des troisièmes transducteurs 63.2, s'étendant entre des côtés des corps sismiques 3.1, 3.2 en regard, le capteur comportant deux troisièmes transducteurs 63.2 disposés sur deux côtés adjacents.

Le bâti 52 a été formé par gravure de toutes les couches ; le fond 59.2 est formé uniquement dans la couche semi-conductrice 101.3 ; la bordure 59.1 et le plot 59.3 sont formés dans les couches 100.1, 101.1, 100.2, 101.2 ; les corps sismiques 53.1, 53.2 sont formés dans les couches 100.1, 100.2, 101.1 ; les premiers et deuxièmes éléments élastiques sont formés dans les couches 100.1, 100.2, 101.1 ; et les troisièmes éléments élastiques ont été formés dans les couches semi-conductrices 100.1, 100.2, 101.1. La couche isolante 101.2 a été partiellement éliminée pour ne pas entraver les mouvements des corps sismiques 53.1, 53.2 et des éléments élastiques par rapport au fond 59.2.

Comme précédemment, les corps sismiques 3.1, 3.2 ont une même masse et sont positionnés pour avoir des centres de gravité confondus l'un avec l'autre. Les corps sismiques sont mobiles par rapport au cadre intermédiaire 59 et au bâti 52 dans un plan de suspension P.

Les premiers éléments élastiques 58.11, 58.12 et les deuxièmes éléments élastiques 58.2 forment un premier étage de suspension et un deuxième étage de suspension des corps sismiques 53.1, 53.2.

Les éléments élastiques sont ici formés de lamelles élastiquement déformables parallèlement au plan de suspension P, mais qui présentent une raideur élevée selon l'axe normal au plan de suspension pour supprimer les degrés de liberté des corps sismiques 53.1, 53.2 hors du plan de suspension P. Les éléments élastiques 58.11, 58.12, 58.2 sont agencés pour assurer un couplage relativement faible du cadre intermédiaire 59 avec les corps sismiques 53.1, 53.2 et avec le bâti 52. Les premiers éléments élastiques 58.11, 58.12 ont des raideurs isotropes dans le plan P. Les deuxièmes éléments élastiques 58.2 ont des raideurs isotropes dans le plan P. Les raideurs des premiers éléments élastiques 58.11, 58.12 et des deuxièmes éléments élastiques 58.2 sont telles que les fréquences du premier mode propre du cadre intermédiaire 59 et du mode propre d'ensemble des corps sismiques 53.1, 53.2 soient sensiblement inférieures à la fréquence des modes utiles. Les éléments élastiques 60 ont des raideurs isotropes dans le plan P et sont agencés pour assurer un couplage relativement fort des corps sismiques 53.1, 53,2 entre eux. Les éléments élastiques 60 ont donc une raideur supérieure à la raideur des éléments élastiques 58.11, 58.12, 58.2.

Les transducteurs 61, 62, 63.1, 63.2 sont reliés à une unité de commande, non représentée ici, pour déterminer le mouvement relatif des corps sismiques 53.1, 53.2 l'un par rapport à l'autre.

Les transducteurs 61 sont pilotés par l'unité de commande pour déplacer le cadre intermédiaire 59 par rapport au bâti 52. Les transducteurs 62 sont pilotés par l'unité de commande pour détecter les déplacements du cadre intermédiaire 59 par rapport au bâti 52.

Les transducteurs 63.1 sont pilotés par l'unité de commande de manière à former un actionneur de mise en vibration des corps sismiques 53.1, 53.2 et les transducteurs 63.2 sont pilotés par l'unité de commande de manière à former un détecteur du déplacement relatif des corps sismiques 53.1, 53.2.

Comme dans le premier mode de réalisation, la couche semi-conductrice 100.1 et/ou les couches 100.1, 101.1 sont pourvues sur toute la hauteur de fentes 64, 65, 66 ménagées dans le bâti 52, la bordure 59.1 du cadre intermédiaire 59 et dans le corps sismique 53.2 pour permettre la formation dans ceux-ci de zones de conduction soumises à des potentiels différents. Tout ou partie des éléments élastiques sont utilisés pour relier entre elles des zones qui appartiennent au bâti 52, le cadre intermédiaire 59 et les corps sismiques 53.1, 53.2 et qui sont destinées à être au même potentiel.

Les transducteurs 61, 62, 63.1, 63.2 ont alors chacun une électrode solidaire d'une zone de conduction et une électrode solidaire d'une autre zone de conduction. Ces zones de conduction différentes sont électriquement isolées l'une de l'autre et peuvent donc être portées à des potentiels différents pour transmettre des signaux de commande et/ou de détection.

Les zones de conduction ainsi délimitées permettent la conduction d'un signal de tension entre les transducteurs 61, 62, 63.1, 63.2 et la périphérie du bâti 52. L'unité de commande est électriquement connectée auxdites zones de conduction au niveau de la périphérie du bâti 52.

L'ensemble est monté dans un boîtier 70.

Bien entendu, l'invention n'est pas limitée aux modes de réalisation décrits mais englobe toute variante entrant dans le champ de l'invention telle que définie par les revendications.

En particulier, le capteur peut comporter plus de deux corps sismiques et les corps sismiques peuvent avoir une forme différente de celle décrite.

Le nombre de transducteurs peut être différent de celui décrit. Par exemple, en référence à la figure 8, il est possible de prévoir trois transducteurs 73 par côté des corps sismiques 53.1, 53.3 au lieu d'un seul comme représenté sur la figure 7. Le nombre de zones de conductions est alors plus élevé, de même que le nombre de fentes. Il est alors prévu des éléments déformables supplémentaires pour assurer la liaison de zones appartenant à des composants différents (bâti, cadre intermédiaire, corps sismiques) mais devant être au même potentiel électrique. Les éléments déformables peuvent être agencés pour participer significativement à la suspension ou pas.

En variante, le transducteur 11.1 peut être piloté en détecteur uniquement et le transducteur 12.1 peut être piloté en actionneur uniquement, ou inversement. Il en est de même pour les transducteurs 11.2, 12.2.

Le capteur peut ne pas comporter de boîtier 20.

## Revendications

1. Capteur inertiel de type MEMS (1, 51), comprenant un bâti (2.1, 2.2, 52) au moins un premier corps sismique (3.1, 53.1) et un deuxième corps sismique (3.2, 53.2) reliés audit bâti par des moyens élastiques du capteur (8.11, 8.12) pour être mobiles dans un plan de suspension (P), des transducteurs (13.1, 13.2, 63.1, 63.2) pour maintenir en vibration les corps sismiques et pour déterminer un mouvement des corps sismiques dans le plan de suspension, et une unité de commande reliée aux transducteurs par des moyens de conduction électrique, les transducteurs comportant des électrodes solidaires respectivement du premier corps sismique et du deuxième corps sismique, **caractérisé en ce que** les électrodes sont agencées pour permettre de mesurer directement le mouvement relatif des corps sismiques l'un par rapport à l'autre dans le plan de suspension selon au moins deux directions parallèles au plan de suspension.

2. Capteur selon la revendication 1, comprenant au moins une première couche semi-conductrice (100.1) dans laquelle sont formées au moins une partie des corps sismiques, les moyens élastiques et les électrodes, une première couche isolante électriquement (101.1), et une deuxième couche semi-conductrice (100.2) formant support, la première couche semi-conductrice étant pourvue de rainures sur toute sa hauteur pour définir des chemins de conduction électrique s'étendant depuis les électrodes vers une périphérie du bâti via les moyens élastiques de manière à former au moins une partie des moyens de conduction.

3. Capteur selon la revendication 2, comprenant une deuxième couche isolante (101.2) et une troisième couche semi-conductrice (100.3), la deuxième couche semi-conductrice s'étendant entre les couches isolantes et un cadre support intermédiaire (9.1, 9.2, 59) étant formé dans la deuxième couche semi-conductrice, la troisième couche semi-conductrice formant un bâti.

4. Capteur selon la revendication 3, dans lequel les corps sismiques sont concentriques, le premier corps sismique étant monté dans le deuxième corps sismique et comportant une cavité centrale dans laquelle s'étend un plot (59.3) solidaire de la troisième couche semi-conductrice et le premier corps sismique est relié au plot par des moyens élastiques (58.11).

5. Capteur selon la revendication 1, dans lequel les corps sismiques ont une même forme et une même masse et en ce que les corps sismiques comportent des parties d'emboîtement de telle manière que les corps sismiques soient mutuellement imbriqués l'un dans l'autre tout en étant mobiles dans le plan de suspension relativement à l'autre des corps sismiques, les corps sismiques ayant des centres de gravité confondus l'un avec l'autre.

6. Capteur selon la revendication 5, dans lequel chaque corps sismique comprend deux ailes parallélépipédiques (4.1, 4.2) qui s'étendent parallèlement l'une à l'autre et une âme centrale parallélépipédique (5.1, 5.2) s'étendant en retrait des ailes et par laquelle les ailes sont reliées l'une l'autre, les corps sismiques étant orientés à 90° l'un par rapport à l'autre autour d'un axe normal au plan de suspension et à 180° autour d'un axe du plan de suspension de telle manière que l'âme de chacun des corps sismiques s'étende en regard de l'âme et entre les ailes de l'autre des corps sismiques et que les ailes de chacun des corps sismiques aient des portions d'extrémité s'étendant dans le même plan que l'âme et en regard de portions d'extrémité des ailes de l'autre des corps sismiques.

7. Capteur selon la revendication 6, dans lequel chaque aile a une masse inférieure de moitié à une masse de l'âme.

## Patentansprüche

1. MEMS-Trägheitssensor (1, 51), umfassend einen Rahmen (2.1, 2.2, 52), mindestens einen ersten seismischen Körper (3.1, 53.1) und einen zweiten seismischen Körper (3.2, 53.2), die über elastische Mittel des Sensors (8.11, 8.12) mit dem Rahmen verbunden sind, um in einer Aufhängungsebene (P) beweglich zu sein, Wandler (13.1, 13.2, 63.1, 63.2), um die seismischen Körper in Schwingung zu halten und um eine Bewegung der seismischen Körper in der Aufhängungsebene zu bestimmen, und eine Steuereinheit, die mit den Wandlern über Stromleitungsmittel verbunden ist, wobei die Wandler Elektroden umfassen, die fest mit dem ersten seismischen Körper bzw. mit dem zweiten seismischen Körper verbunden sind, **dadurch gekennzeichnet, dass** die Elektroden so ausgebildet sind, dass sie ein direktes Messen der Relativbewegung der seismischen Körper zueinander in der Aufhängungsebene in mindestens zwei zur Aufhängungsebene parallelen Richtungen gestatten.

2. Sensor nach Anspruch 1, mindestens umfassend eine erste halbleitende Schicht (100.1), in der mindestens ein Teil der seismischen Körper, die elastischen Mittel und die Elektroden ausgebildet sind, eine erste elektrisch isolierende Schicht (101.1) und eine zweite halbleitende Schicht (100.2), die einen Träger bildet, die erste halbleitende Schicht über ihre gesamte Höhe mit Nuten versehen ist, um Stromleitungswege zu definieren, die sich von den Elektroden zu einem Umfang des Rahmens über die elastischen Mittel derart erstrecken, dass sie mindestens einen Teil der Leitungsmittel bilden.

3. Sensor nach Anspruch 2, umfassend eine zweite isolierende Schicht (101.2) und eine dritte halbleitende Schicht (100.3), wobei sich die zweite halbleitende Schicht zwischen den isolierenden Schichten erstreckt und wobei ein Zwischenträgerrahmen (9.1, 9.2, 59) in der zweiten halbleitenden Schicht ausgebildet ist, wobei die dritte halbleitende Schicht einen Rahmen bildet.

4. Sensor nach Anspruch 3, bei dem die seismischen Körper konzentrisch sind, wobei der erste seismische Körper in dem zweiten seismischen Körper montiert ist und einen zentralen Hohlraum umfasst, in dem sich ein Stift (59.3) erstreckt, der fest mit der dritten halbleitenden Schicht verbunden ist, und der erste seismische Körper mit dem Stift über elastische Mittel (58.11) verbunden ist.

5. Sensor nach Anspruch 1, bei dem die seismischen Körper eine gleiche Form und eine gleiche Masse haben und dass die seismischen Körper Steckteile umfassen, derart, dass die seismischen Körper gegenseitig ineinander verschachtelt sind, während sie in der Aufhängungsebene relativ zum anderen der seismischen Körper beweglich sind, wobei die seismischen Körper Schwerpunkte haben, die miteinander zusammenfallen.

6. Sensor nach Anspruch 5, bei dem jeder seismische Körper zwei parallelepipedische Flügel (4.1, 4.2) hat, die sich parallel zueinander erstrecken und einen parallelepipedischen zentralen Kern (5.1, 5.2), der sich zurückversetzt zu den Flügeln erstreckt und durch den die Flügel miteinander verbunden sind, wobei die seismischen Körper um 90° zueinander um eine Achse senkrecht zur Aufhängungsebene und um 180° um eine Achse der Aufhängungsebene ausgerichtet sind, derart, dass sich der Kern jedes der seismischen Körper gegenüber dem Kern und zwischen den Flügeln des anderen der seismischen Körper erstreckt und dass die Flügel jedes der seismischen Körper Endabschnitte haben, die sich in einer selben Ebene wie der Kern und gegenüber von Endabschnitten der Flügel des anderen der seismischen Körper erstrecken.

7. Sensor nach Anspruch 6, bei dem jeder Flügel eine Masse hat, die um die Hälfte geringer als eine Masse des Kerns ist.

## Claims

1. A MEMS type inertial sensor (1, 51) comprising a support structure(2.1, 2.2, 52), having at least a first seismic body (3.1, 53.1) and a second seismic body (3.2, 53.2) connected to said support structure thereto by resilient means of the sensor (8.11, 8.12) in order to be movable in a suspension plane (P), transducers (13.1, 13.2, 63.1, 63.2) for maintaining the seismic bodies in vibration and for determining movements of the seismic bodies in the suspension plane, and a control unit connected to the transducers by electrical conductor means, the sensor being the transducers having electrodes secured respectively to the first seismic body and to the second seismic body, **characterized in that** the electrodes are arranged to make it possible to measure directly movements of the seismic bodies relative to each other in the suspension plane, in at least two directions parallel to the suspension plane.

2. A sensor according to claim 1, including at least a first semiconductor layer (100.1) in which there are formed at least a portion of the seismic bodies, the resilient means, and the electrodes, a first electrically insulating layer (101.1), and a second semiconductor layer (100.2) forming a support, the first semiconductor layer being provided with slots through its full height in order to define electrical conduction paths extending from the electrodes to the periphery of the support structure via the resilient means so as to form at least some of the conduction means.

3. A sensor according to claim 2, having a second insulating layer (101.2) and a third semiconductor layer (100.3), the second semiconductor layer extending between the insulating layers and an intermediate support frame (9.1, 9.2, 59) being formed in the second semiconductor layer, the third semiconductor layer forming a support structure.

4. A sensor according to claim 3, wherein the seismic bodies are concentric, the first seismic body being mounted in the second seismic body and including a central cavity in which there extends a stud (59.3) secured to the third semiconductor layer, and the first seismic body is connected to the stud by resilient means (58.11).

5. A sensor according to claim 1, wherein the seismic bodies are of the same shape and have the same mass, and in that the seismic bodies include mutual engagement portions in such a manner that the seismic bodies are nested in one another while being movable in the suspension plane relative to one another, the seismic bodies having centers of gravity that coincide.

6. A sensor according to claim 5, wherein each seismic body has two wings in the form of rectangular parallelepipeds (4.1, 4.2) that extend parallel to each other and a central core in the form of a rectangular parallelepiped (5.1, 5.2) that is set back from the wings, and by which the wings are connected to each other, the seismic bodies being oriented at 90° relative to each other about an axis normal to the suspension plane and at 180° about an axis in the suspension plane in such a manner that the core of each seismic body extends facing the core and between the wings of the other seismic body, and the wings of each seismic body have end portions extending in the same plane as the core and facing end portions of the wings of the other seismic body.

7. A sensor according to claim 6, wherein each wing is of mass that is less than half the mass of the core.
